# EUROPEAN PATENT APPLICATION

(11) **EP 1 916 702 A2**
(43) Date of publication of application: **30.04.2008**
(21) Application number: 07019255.4
(22) Date of filing: 01.10.2007
(51) Int. Cl.: H01L 21/02, H01L 21/3213

(54) **Method of manufacturing a thin-film transistor substrate**

(30) Priority: 23.10.2006 KR 20060102709
(71) Applicant: Samsung Electronics Co., Ltd., Yeongtong-gu Suwon-city, Gyeonggi-do 442-742 (KR)
(72) Inventor: Lee, Duck-Jung, Cheonan-si Chungcheongnam-do (KR); Kim, Kyung-Seop, Suwon-si, Gyeonggi-do (KR); Lee, Yong-Eui, Seongnam-si, Gyeonggi-do (KR); Park, Myung-Il, Daejeon (KR); Lee, Dong-Chin, Cheonan-si, Chungcheongnam-do (KR)
(74) Representative: Dr. Weitzel & Partner

(57) **Abstract**

A gate insulating layer, an active layer and a data metal film are sequentially formed on a substrate. A first photoresist pattern having a relatively small thickness in a channel forming area with respect to a thickness of the photoresist pattern not in the channel forming area is formed on the data metal film. The data metal film and the active layer are sequentially etched using the first photoresist pattern. The active layer is etched using the first photoresist pattern. The first photoresist pattern is dry etched using a gas mixture including a sulfur hexafluoride gas and an oxygen gas to form a second photoresist pattern with an opening formed in the channel forming area. The data metal film is then etched using the second photoresist pattern. Dry, wet or acid cleaning procedures used within the manufacturing method reduce formation of stringers in the substrate.

## Description

This application claims priority to Korean Patent Application No. 2006-102709, filed on October 23, 2006, and all the benefits accruing therefrom under 35 U.S.C. § 119, the contents of which in its entirety are herein incorporated by reference.

### BACKGROUND OF THE INVENTION

### 1. Field of the Invention

The present invention relates to a method of manufacturing a thin-film transistor ("TFT") substrate. More particularly, the present invention relates to a method of manufacturing a TFT substrate which reduces undesirable phenomena (e.g., the formation of stringers) associated with etching a metal film during the manufacturing process.

### 2. Description of the Related Art

Generally, a liquid crystal display ("LCD") device includes a TFT substrate, a color filter substrate and a liquid crystal layer interposed therebetween. The TFT substrate includes a plurality of TFTs and a plurality of pixel electrodes. The color filter substrate includes a color filter and a common electrode.

The TFT substrate is manufactured through a photolithography process using a mask. In order to reduce manufacturing time and costs thereof, a four-mask process has been developed.

Conventionally, the four-mask process which etches a data metal film includes a first etching process for forming a data line, and a second etching process for etching a channel forming area.

In the four-mask process, the first and second etching processes are performed through a wet etching process. However, the wet etching process is isotropic, which makes it difficult to form a fine pattern (e.g., the wet echant erodes the TFT substrate in all directions, leading to bias or undercut). Moreover, the wet etching process may extrude an active layer rather than a metal line, thus decreasing an aperture ratio and generating a residual image.

In order to solve the problems described above, a wet etching process can be used in the first etching process and a dry etching process can be used in the second etching process. However, the wet etching process generates and leaves behind metal oxide, polymer, and/or organic remaining substances which form stringers (e.g., non-etched portions of the metal film) during the second etching process.

### BRIEF SUMMARY OF THE INVENTION

The present invention provides a method of manufacturing a thin film transistor ("TFT") substrate which effectively eliminates or reduces stringers which are generated when a data metal film is dry etched.

In one exemplary embodiment of the present invention, a gate insulating layer, an active layer and a data metal film are sequentially formed on a substrate having a gate line formed thereon. A first photoresist pattern is formed on the data metal film. The first photoresist pattern corresponding to a channel forming area has a small thickness with respect to a thickness of the first photoresist pattern corresponding to the remaining area. The data metal film is first etched using the first photoresist pattern. Then the active layer is etched using the first photoresist pattern. The first photoresist pattern is then dry etched using a gas mixture including sulfur hexafluoride ("SF₆") gas and oxygen ("O₂") gas having an SF₆ to O₂ ratio of about 1:4 to about 1:20 to form a second photoresist pattern which has an opening formed in the channel forming area. The data metal film is then second etched using the second photoresist pattern.

After the data metal film is second etched, the second photoresist pattern is removed, and a passivation layer which has an opening which partially exposes the data metal film is formed, and a pixel electrode is formed thereon.

The first etching of the data metal film may be processed by a wet etching process, and the second etching of the data metal film may be processed by a dry etching process.

The data metal film may have a triple-layered structure of a molybdenum (Mo) layer, an aluminum (Al) layer and a molybdenum (Mo) layer sequentially stacked.

Undesired remaining substances from the first etching of the data metal film such as metal oxide, polymer, and/or organic substances are removed before the data metal film is second etched. A dry cleaning process may be performed with a sulfur hexafluoride ("SF₆") gas, an argon (Ar) gas, a boron trichloride ("BCl₃") gas, a nitrogen trifluoride ("NF₃") gas, a bromine (Br) gas, an oxygen ("O₂") gas or a mixture thereof.

In another exemplary embodiment, a wet cleaning of the remaining substances may be performed before the data metal film is second etched. The wet cleaning process may be performed by a tetramethylammonium hydroxide ("TMAH") cleaning process, an isopropyl alcohol ("IPA") cleaning process or a deionized ("DI") water cleaning process.

In yet another exemplary embodiment, an acid cleaning of remaining substances may be performed before the data metal film is second etched. The acid cleaning process may be performed by any one selected from a diluted fluoroboric acid, a diluted sulfuric acid, a diluted phosphoric acid, a diluted nitric acid, a diluted acetic acid or a mixture thereof. The acid cleaning process may be performed having a solution mixture which has an acid to DI water ratio of about 1:100 to about 1:3,000.

The dry, wet and acid cleaning processes described above are not limited to use immediately prior to etching the data metal film the second time (e.g., the cleaning processes may be performed after etching the active layer with the first photoresist pattern). Furthermore, the first etching of the data metal film may be a wet etching process, as described in another exemplary embodiment of the present invention, wherein a gate insulating layer, an active layer and a data metal film are sequentially formed on a substrate having a gate line formed thereon. A first photoresist pattern corresponding to a channel forming area having a small thickness with respect to a thickness of the first photoresist pattern corresponding to the remaining area, is then formed on the data metal film and the data metal film is first dry etched using the first photoresist pattern. Then, the active layer is etched using the first photoresist pattern. At that point, remaining substances are dry, wet or acid cleaned as described above. Then the first photoresist pattern is dry etched to form a second photoresist pattern having an opening formed in the channel forming area. Then, the data metal film is second dry etched using the second photoresist pattern.

After the data metal film is second dry etched, the second photoresist pattern is be removed, and a passivation layer which has an opening which partially exposes the data metal film is formed, and a pixel electrode is formed thereon.

### BRIEF DESCRIPTION OF THE DRAWINGS

The above and other aspects, features and advantages of the present invention will become more apparent by describing in further detail exemplary embodiments thereof with reference to the accompanying drawings, in which:
FIG. 1 is a plan view illustrating a thin-film transistor ("TFT") substrate manufactured according to an exemplary embodiment of the present invention;
FIGS. 2 to 6 and 8 to 10 are partial cross-sectional views taken along line I-I' of FIG. 1 illustrating an exemplary embodiment of a manufacturing process of the TFT substrate in FIG. 1;
FIG. 7A is a microphotograph illustrating whether a stringer was formed on a sample substrate when oxygen was used as an etching gas;
FIG. 7B is a microphotograph illustrating whether a stringer was formed on a sample substrate when a sulfur hexafluoride-oxygen mixture was used as an etching gas.

### DETAILED DESCRIPTION OF THE INVENTION

The invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," or "includes" and/or "including," when used in this specification, specify the presence of stated features, regions, integers, steps, operations, elements and/or components, but do not preclude the presence or addition of one or more other features, regions, integers, steps, operations, elements, components and/or groups thereof.

Furthermore, relative terms, such as "lower" or "bottom" and "upper" or "top" may be used herein to describe one element's relationship to other elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on the "upper" side of the other elements. The exemplary term "lower" can, therefore, encompass both an orientation of "lower" and "upper," depending upon the particular orientation of the figure. Similarly, if the device in one of the figures were turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning which is consistent with their meaning in the context of the relevant art and the present disclosure, and will not be interpreted in an idealized or overly formal sense unless expressly so defined herein.

Exemplary embodiments of the present invention are described herein with reference to cross section illustrations which are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes which result, for example, from manufacturing. For example, a region illustrated or described as flat may, typically, have rough and/or nonlinear features. Moreover, sharp angles which are illustrated may be rounded. Thus, the regions illustrated in the figures are schematic in nature and their shapes are not intended to illustrate the precise shape of a region and are not intended to limit the scope of the present invention.

Hereinafter, a method of manufacturing a thin-film transistor ("TFT") substrate according to an exemplary embodiment of the present invention will be described in further detail with reference to the accompanying drawings.

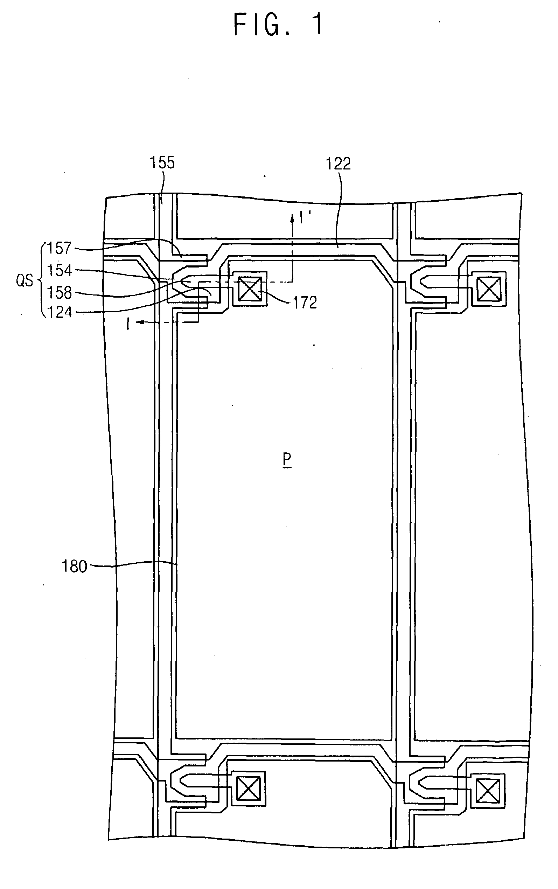

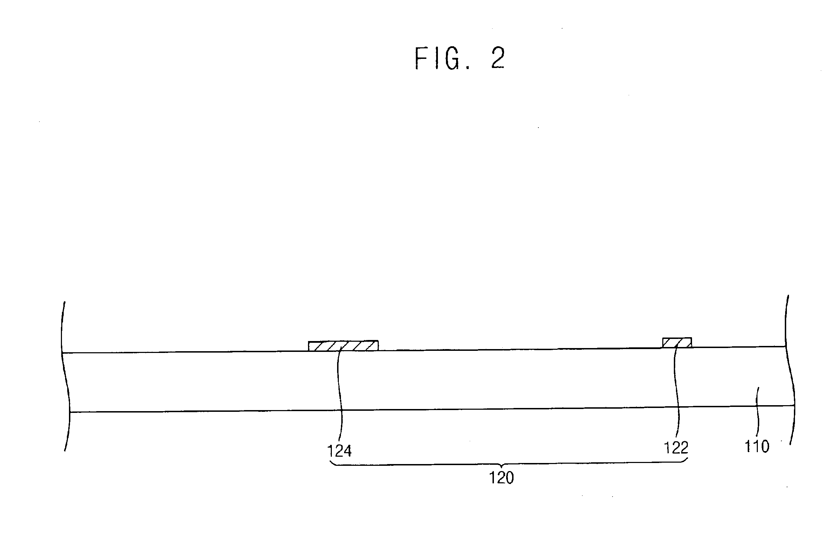

FIG. 1 is a plan view illustrating a TFT substrate manufactured according to an exemplary embodiment of the present invention. FIGS. 2 to 6 and 8 to 10 are partial cross-sectional views taken along line I-I' of FIG. 1 illustrating the manufacturing process of the TFT substrate in FIG. 1.

Referring to FIGS. 1 and 2, a gate metal film (not shown) is formed on a substrate 110, and the gate metal film is patterned through a photolithography process using an exposing mask to form a gate wiring 120 including a gate line 122 and a gate electrode 124 which is electrically connected to the gate line 122. The gate metal film may be deposited on the substrate 110 by using, for example, but is not limited thereto, a sputtering process or a chemical vapor deposition ("CVD") process.

The substrate 110 may include a transparent insulating substrate, e.g., a glass substrate or other suitable material.

The gate wiring 120 may include, for example, but is not limited thereto, a metallic material such as chromium (Cr), aluminum (Al), tantalum (Ta), molybdenum (Mo), titanium (Ti), tungsten (W), copper (Cu) or silver (Ag), or a metal alloy thereof. The gate wiring 120 may have at least a double-layered structure of metallic materials having different physical characteristics. In one exemplary embodiment, for example, the gate wiring 120 includes a first metal layer and a second metal layer which is sequentially formed on the first metal layer. The first metal layer includes at least one of aluminum (Al) and an aluminum alloy. The second metal layer includes at least one of molybdenum (Mo) and a molybdenum (Mo) alloy.

The gate line 122 may be elongated along a substantially horizontal direction to define upper sides and lower sides of each pixel P, as illustrated in FIG. 1. The gate electrode 124 is electrically connected to the gate line 122, so that the gate electrode 124 defines a gate terminal of a TFT QS formed in a respective pixel P.

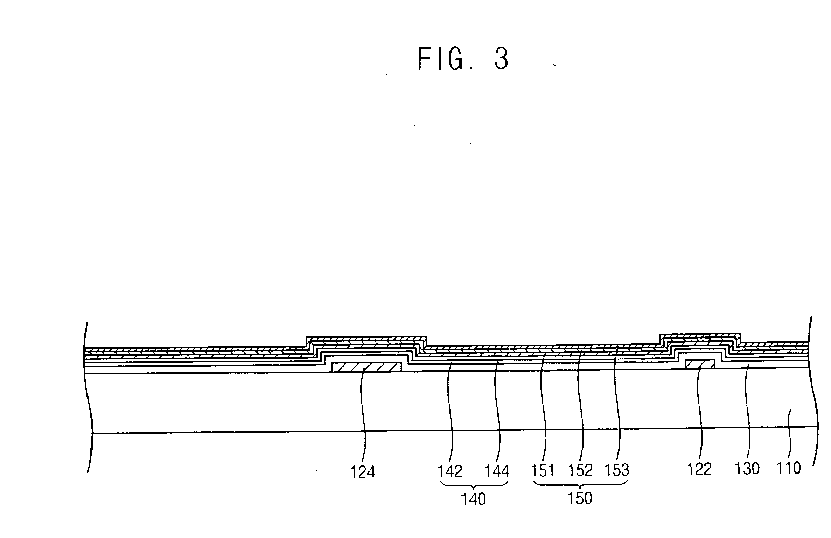

Referring to FIG. 3, a gate insulating layer 130, an active layer 140 and a data metal film 150 are sequentially formed on the substrate 110 having the gate wiring 120 formed thereon.

The gate insulating layer 130 and the active layer 140 may be formed by using, for example, a plasma-enhanced chemical vapor deposition ("PECVD") process, and the data metal film 150 may be formed by using, for example, a sputtering process or a CVD process. Alternatively, the gate insulating layer 130, the active layer 140, and the data metal film 150 may be formed by other appropriate methods not specifically identified herein.

The gate insulating layer 130 protects the gate wiring 120 and electrically isolates the gate line from other metal films or other metal layers. The gate insulating layer 130 may include silicon nitride ("SiNₓ"), silicon oxide ("SiOₓ"), or other suitable material. A thickness of the gate insulating layer 130 may be about 4500

The active layer 140 may include a channel layer 142 and an ohmic contact layer 144. For example, the channel layer 142 includes amorphous silicon ("a-Si"). The ohmic contact layer 144 includes amorphous silicon with highly- concentrated n-type dopants ("n+ a-Si").

The data metal film 150 may be a triple-layered structure to have a low electrical resistance. For example, in one exemplary embodiment, the data metal film 150 includes molybdenum (Mo) 151, aluminum (Al) 152 which is sequentially formed on the molybdenum (Mo) 151, and molybdenum (Mo) 153 which is sequentially formed on the aluminum (Al) 152. Alternatively, the data metal film 150 may include, for example, but is not limited to, a metallic material such as aluminum (Al), molybdenum (Mo), chromium (Cr), tantalum (Ta), titanium (Ti), tungsten (W), copper (Cu) or silver (Ag), or a metal alloy thereof.

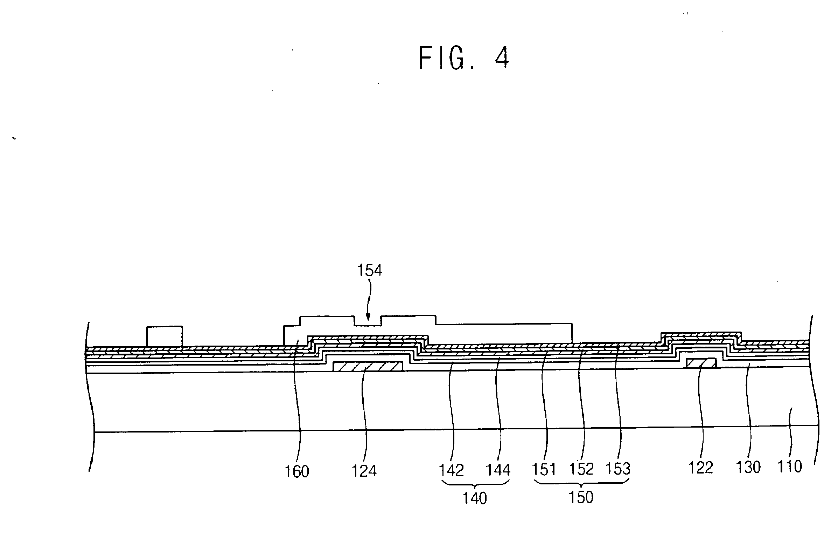

Referring to FIG. 4, a photoresist film is formed on the data metal film 150, and then the photoresist film is patterned to form a first photoresist pattern 160 by using, for example, a photolithography process which uses a mask such as a slit mask or a half tone mask, etc. The photoresist film may include a positive photoresist, so that an exposed area is removed by a developing solution. Alternatively, the photoresist film may include a negative photoresist.

The first photoresist pattern 160 has a relatively small thickness in a channel forming area 154 with respect to a thickness of the photoresist pattern 160 not in the channel forming area 154. For example, the channel forming area 154 of the first photoresist pattern 160 may have a thickness of about 5,000 to about 8,000 .

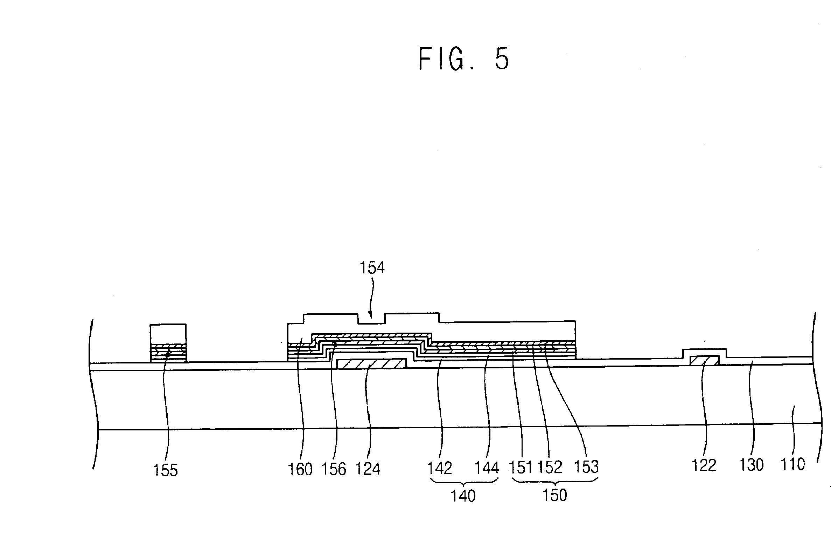

Referring to FIGS. 1 and 5, the data metal film 150 is first etched using the first photoresist pattern 160 as an etch-stop layer. According to one exemplary embodiment of the present invention, the first etching of the data metal film 150 is performed by a wet etching process.

When the data metal film 150 is wet etched using the first photoresist pattern 160, a data line 155 and a source/drain metal pattern 156 are formed. The data line 155 may be elongated along a substantially vertical direction which crosses the gate line 122 to define left sides and right sides of the pixel P as illustrated in FIG. 1.

Next, the active layer 140 is etched using the first photoresist pattern 160 as an etch-stop layer. The etching process of the active layer 140 may be a dry etching process. After the etching process of the active layer 140 using the first photoresist pattern 160, portions of the active layer 140 remain below the data line 155 and the source/drain metal pattern 156. That is, the data metal film 150 and the active layer 140 are etched using the same first photoresist pattern 160, so that a boundary portion of the remaining active layer 140 is substantially matched to a boundary portion of the data line 155 and a boundary portion of the source/drain metal pattern 156, as illustrated in FIG. 5.

After the first wet etching of the data metal film 150 and the dry etching of the active layer 140, an undesirable metal oxide layer such as oxide aluminum ("AlxOy"), etc. may form on a surface of the data metal film 150 exposed to the atmosphere (e.g., an etching surface of the data metal film 150 which is not covered by the first photoresist pattern 160). Additionally, metal oxide, polymer and/or organic remaining substances (collectively referred to hereinafter as "remaining substances") from the first wet etching process may remain on a surface of the data metal film 150.

The metal oxide layer or the remaining substances on the surface of the data metal film 150 decreases etching rate during subsequent etchings such that some surfaces are not etched (e.g., a stringer is formed) during the subsequent etching process. Therefore, it is beneficial to minimize the amount of time which the data metal film 150 is exposed to the atmosphere after the first wet etching of the data metal film 150 and the dry etching of the active layer 140. Furthermore, using a stocker (not shown) which maintains a nitrogen ("N₂") gas atmosphere, further reduces metal oxide layer formation on an exposed surface of the data metal film 150.

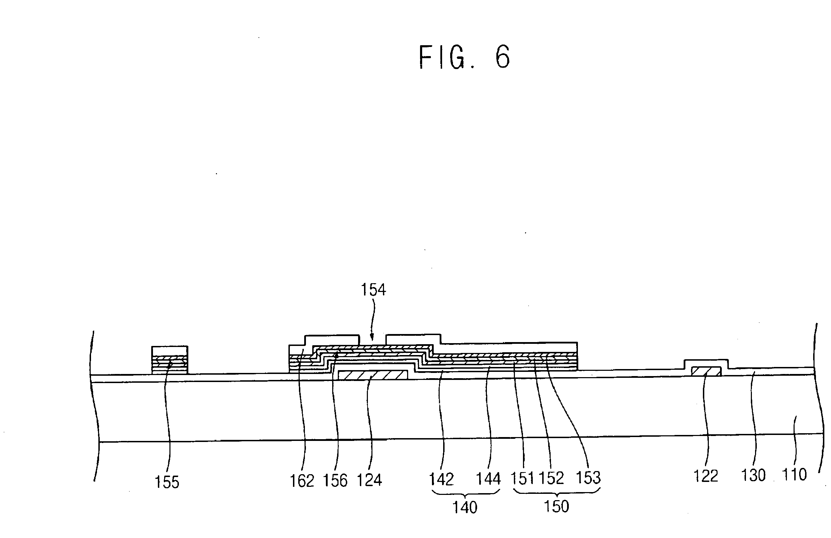

Referring to FIGS. 5 and 6, the first photoresist pattern 160 is dry etched to form a second photoresist pattern 162 having an opening formed thereon in the channel forming area 154. Therefore, the source/drain metal pattern 156 corresponding to the channel forming area 154 is exposed.

In order to dry etch the first photoresist pattern 160 to form the second photoresist pattern 162, a sulfur hexafluoride ("SF₆") gas and oxygen ("O₂") gas composition may be used as an etching gas. A ratio of the sulfur hexafluoride ("SF₆") gas to the oxygen ("O₂") gas is controlled, so that the dry etching of the first photoresist pattern 160 and the cleaning process which removes any remaining substances on a surface of the data metal film 150 are simultaneously completed.

According to one exemplary embodiment, an ideal ratio of the sulfur hexafluoride ("SF₆") gas to the oxygen ("O₂") gas is about 1:4 to about 1:20. Alternatively, a ratio of the sulfur hexafluoride ("SF₆") gas to the oxygen ("O₂") gas may be about 1:30 to about 1:40.

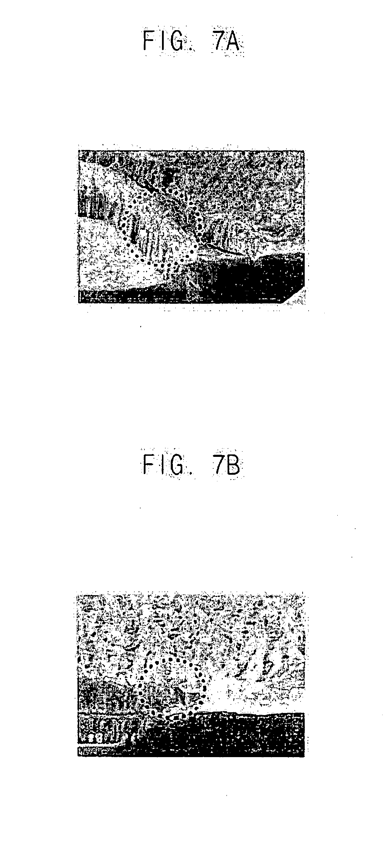

Excess sulfur hexafluoride ("SF₆") may damage the active layer 140 and the gate insulating layer 130. Conversely, insufficient sulfur hexafluoride ("SF₆") gas reduces the cleaning effect of the sulfur hexafluoride ("SF₆") gas and the oxygen ("O₂") gas composition. Two experiments were performed to test the efficacy of using a mixture of hexafluoride ("SF₆") gas and the oxygen ("O₂") gas according to an exemplary embodiment of the present invention, as illustrated in FIGS. 7A and 7B.

FIG. 7A is a microphotograph illustrating whether a stringer was formed on a sample substrate when oxygen was used as an etching gas and FIG. 7B is a microphotograph illustrating whether a stringer was formed on a sample substrate when a sulfur hexafluoride-oxygen mixture was used as an etching gas. More specifically, FIG. 7A illustrates whether a stringer was generated when pure oxygen ("O₂") gas was used as an etching gas for about 30 seconds at a pressure of about 50mT, and FIG. 7B illustrates whether a stringer was generated when a mixture of sulfur hexafluoride ("SF₆") gas and oxygen ("O₂") gas at a ratio of about 1:10 was used as an etching gas for about 30 seconds at a pressure of about 50mT. When only oxygen ("O₂") gas was used as an etching gas, a large amount of stringers can be seen in an end portion of the active and gate insulating layers, as indicated in the area within the circle shown in FIG. 7A. On the other hand, when the sulfur hexafluoride ("SF₆") gas and the oxygen ("O₂") gas mixture was used as an etching gas, the amount of stringers seen in an end portion of the active and gate insulating layers was effectively reduced or eliminated, as indicated in the area within the circle shown in FIG. 7B.

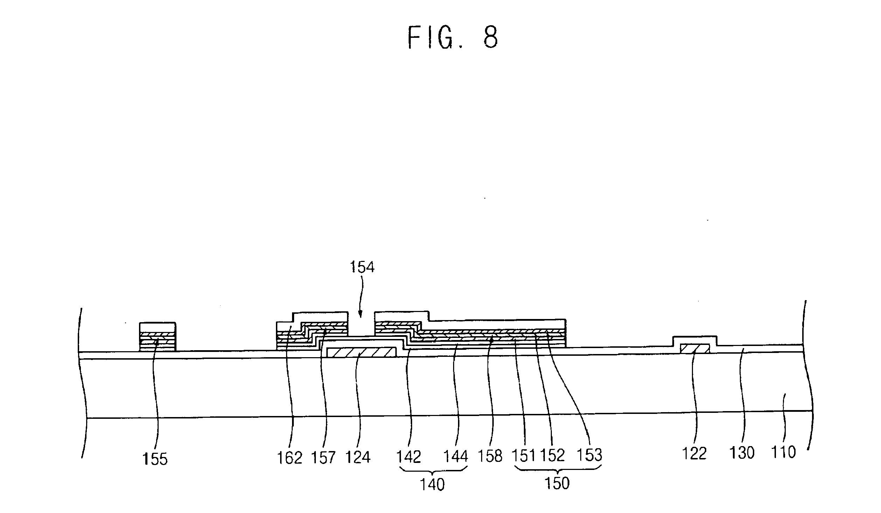

Returning to an exemplary embodiment of the present invention in reference to FIGS. 1 and 8, after the first photoresist pattern 160 is etched to form the second photoresist pattern 162, the data metal layer 150 is second etched using the second photoresist pattern 162 as an etch-stop layer near the channel forming area 154 on the data metal layer 150. The second etching process of the data metal layer 150 may include a dry etching process.

In order to form the data metal layer 150 through the second dry etching process, each of the upper molybdenum (Mo) layer 153, the aluminum (Al) layer 152 and the lower molybdenum (Mo) layer 151 may be dry etched in three separate dry etching processes. Alternatively, two separate dry etching processes may be used, for example, but is not limited to, dry etching the upper molybdenum (Mo) layer 153, and then simultaneously dry etching the aluminum layer 152 and the lower molybdenum (Mo) layer 151.

As a result of the second dry etching of the data metal layer 150 using the second photoresist pattern 162, a source electrode 157 and a drain electrode 158 are formed. The source electrode 157 is electrically connected (connection not shown) to the data line 155 to define a source terminal of the TFT QS. The drain electrode 158 is spaced apart from the source electrode 157 to define a drain terminal (not labeled) of the TFT QS.

An ohmic contact layer 144 of the channel forming area 154 is formed using the second photoresist pattern 162 as an etch-stop layer. Hence, a portion of the channel layer 142 is exposed between the source electrode 157 and the drain electrode 158, thereby completing formation of the TFT QS.

Then, the second photoresist pattern 162, which remains on the data line 155, the source electrode 157 and the drain electrode 158, is removed. The second photoresist pattern 162 may be removed through a strip process using a strip solution or other suitable process.

Prior to the second dry etching of the data metal film 150, a dry cleaning process may be performed to remove any remaining substances which are formed on a surface of the data metal film 150. The dry cleaning process may be performed using a gas such as a sulfur hexafluoride ("SF₆") gas, an argon (Ar) gas, a boron trichloride ("BCl₃") gas, a nitrogen trifluoride ("NF₃") gas, a bromine (Br) gas, an oxygen ("O₂") gas, or other suitable gas. When the sulfur hexafluoride ("SF₆") gas is used in the dry cleaning process, the dry cleaning process is simultaneously performed in conjunction with the dry etching process of the first photoresist pattern 160 which uses the sulfur hexafluoride ("SF6") and oxygen ("O₂") gas mixture as an etching gas.

Alternatively, a wet cleaning process may be performed prior to the second dry etching of the data metal film 150 to remove any remaining substances which are formed on a surface of the data metal film 150. The wet cleaning process may include a tetramethylammonium hydroxide ("TMAH") cleaning process, an isopropyl alcohol ("IPA") cleaning process, or a deionized ("DI") water cleaning process, for example, but is not limited thereto. For example, a concentration of the TMAH may be no more than about 0.4%.

As a further alternative, an acid cleaning process may be performed prior to the second dry etching of the data metal film 150 to remove any remaining substances which are formed on a surface of the data metal film 150. The acid cleaning process may be performed by a solution of DI water mixed with fluoroboric acid, sulfuric acid, phosphoric acid, nitric acid or diluted acetic acid, or a solution thereof. In one exemplary embodiment, an acid to a DI water ratio of about 1:100 to about 1:3,000 may be used.

As described above, the dry cleaning process, the wet cleaning process or the acid cleaning process is performed before the data metal film 150 is second dry etched, so that any remaining substances generated after performing the first wet etching process to the data metal film 150 may be removed, thereby preventing or reducing the formation of stringers.

In the second dry etching process of the data metal film 150, setting a temperature of a stage, which holds the substrate 110, to at least about 50 degrees Celsius, will further reduce or prevent generation of stringers, since an increased temperature of the substrate 110 increases a reaction probability between an etching gas and an object to be etched.

In the second dry etching process of the data metal film 150, any remaining substances formed on a surface of the data metal film 150 may be further effectively removed by increasing a flow velocity of the etching gas in a reaction chamber. For example, an auto pressure control ("APC") function of etching equipment may be set to increase the flow velocity of the etching gas by at least about 15%.

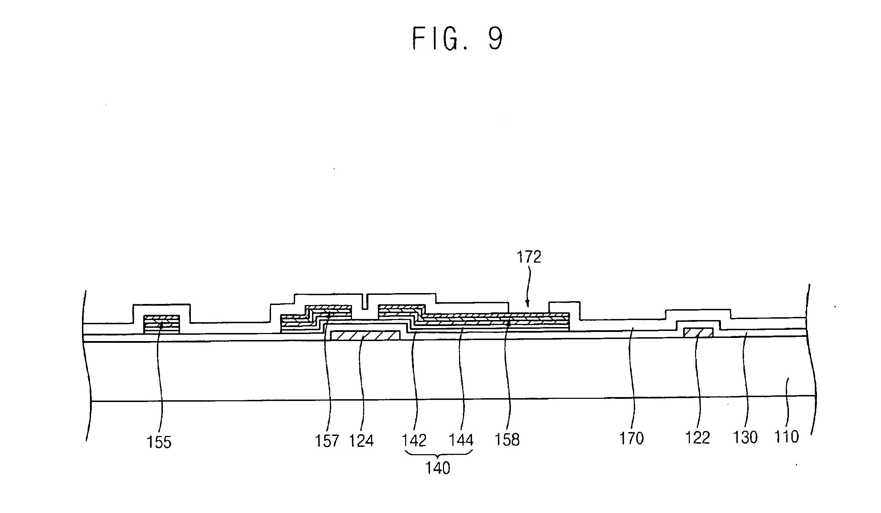

Referring to FIGS. 1 and 9, a passivation layer 170 is formed on the substrate 110 having the TFT QS formed thereon. The passivation layer 170 is an insulating layer for protecting and insulating the TFT QS and the data line 155. The passivation layer 170 may include nitride silicon ("SiNx") and oxide silicon ("SiOx"). The passivation layer 170 may be formed through a CVD process and have a thickness of about 500 to about 2000 .

Then, the passivation layer 170 is patterned through a photolithography process using a exposing mask to form a contact hole 172 which exposes a portion of the drain electrode 158.

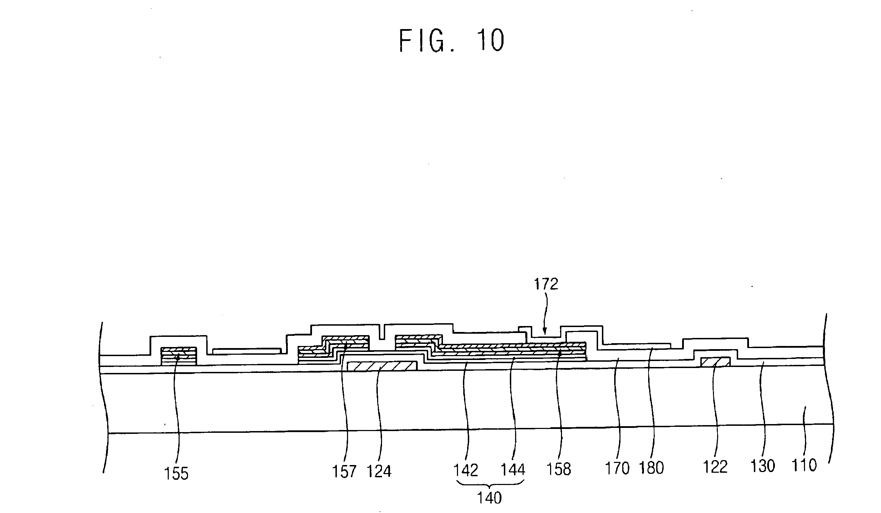

Referring to FIGS. 1 and 10, a transparent conductive layer (not fully shown) is formed on the passivation layer 170, and the transparent conductive layer is patterned through a photolithography process using an exposing mask to form a pixel electrode 180 in the pixel P.

The pixel electrode 180 is electrically connected to the drain electrode 158 through the contact hole 172 formed in the passivation layer 170. The pixel electrode 180 may include indium zinc oxide ("IZO") or indium tin oxide ("ITO"), but is not limited thereto.

An organic insulating layer (not shown) may be formed sequentially on the passivation layer 170 or independently without the separate passivation layer 170 to planarize a surface of the passivation layer 170 before the pixel electrode 180 is formed.

In one exemplary embodiment of the present invention, the first etching of the data metal film 150 is a wet etch; alternatively, the first etching of the data metal film 150 may be a dry etch. In another alternative exemplary embodiment, wet, dry, or acid cleaning (as described above) may be performed prior to etching the second photo resist pattern 162. Furthermore, in alternate exemplary embodiments, the etching of the second photoresist pattern 162 may be a wet or a dry etch process.

Although exemplary embodiments of the present invention have been described herein, it is understood that the present invention should not be limited to these exemplary embodiments, rather various changes and modifications can be made by one of ordinary skill in the art within the spirit and scope of the present invention, as hereinafter claimed.

## Claims

1. A method of manufacturing a thin-film transistor substrate, the method comprising:
sequentially forming a gate insulating layer, an active layer and a data metal film on a substrate having a gate line formed thereon;
forming a first photoresist pattern on the data metal film, the first photoresist pattern corresponding to a channel forming area having a small thickness with respect to a thickness of the first photoresist pattern corresponding to the remaining area;
etching first the data metal film using the first photoresist pattern;
etching the active layer using the first photoresist pattern;
dry etching the first photoresist pattern using a gas mixture including a sulfur hexafluoride (SF₆) gas and an oxygen (O₂) gas with an SF₆ to O₂ ratio of about 1:4 to about 1:20 to form a second photoresist pattern having an opening formed in the channel forming area; and
etching second the data metal film using the second photoresist pattern.

2. The method of claim 1, wherein the etching first of the data metal film is a wet etching process.

3. The method of claim 1, wherein the etching second of the data metal film is a dry etching process.

4. The method of claim 1, wherein the data metal film has a triple-layered structure comprising a molybdenum (Mo) layer, an aluminum (Al) layer and a molybdenum (Mo) layer sequentially stacked.

5. The method of claim 1, further comprising:
cleaning remaining substances from a surface of the data metal film before the second etching of the data metal film.

6. The method of claim 5, wherein the cleaning process comprises a dry cleaning process.

7. The method of claim 6, wherein the dry cleaning process comprises at least one selected from the group consisting of a sulfur hexafluoride (SF₆) gas, an argon (Ar) gas, a boron trichloride (BCl₃) gas, a nitrogen trifluoride (NF₃) gas, a bromine (Br) and an oxygen (O₂) gas.

8. The method of claim 5, wherein the cleaning process comprises a wet cleaning process.

9. The method of claim 8, wherein the wet cleaning process comprises a tetramethylammonium hydroxide (TMAH) cleaning process, an isopropyl alcohol (IPA) cleaning process or a deionized water cleaning process.

10. The method of claim 9, wherein a concentration of the TMAH is no more than about 0.4%.

11. The method of claim 5, wherein the cleaning process comprises an acid cleaning process.

12. The method of claim 11, wherein the acid cleaning process is performed using at least one diluted acid selected from the group consisting of a diluted fluoroboric acid, a diluted sulfuric acid, a diluted phosphoric acid, a diluted nitric acid and a diluted acetic acid.

13. The method of claim 12, wherein the acid cleaning process is performed using a solution in which an acid and deionized water are mixed to an acid to deionized water ratio of about 1:100 to about 1:3,000.

14. The method of claim 1, further comprising:
removing the second photoresist pattern;
forming a passivation layer having an opening formed thereon to partially expose the data metal film on the substrate; and
forming a pixel electrode on the passivation layer.

15. A method of manufacturing a thin-film transistor substrate, the method comprising:
sequentially forming a gate insulating layer, an active layer and a data metal film on a substrate having a gate line formed thereon;
forming a first photoresist pattern on the data metal film, the first photoresist pattern corresponding to a channel forming area having a small thickness with respect to a thickness of the first photoresist pattern corresponding to the remaining area;
dry etching first the data metal film using the first photoresist pattern;
etching the active layer using the first photoresist pattern;
acid cleaning remaining substances from a surface of the data metal;
dry etching the first photoresist pattern to form a second photoresist pattern having an opening formed in the channel forming area, the opening exposing a portion of the data metal film; and
dry etching second the data metal film using the second photoresist pattern.

16. The method of claim 15, wherein the data metal film comprises a triple-layered structure of a molybdenum (Mo) layer, an aluminum (Al) layer and a molybdenum (Mo) layer sequentially stacked.

17. The method of claim 15, wherein the acid cleaning process is performed using at least one diluted acid selected from the group consisting of a diluted fluoroboric acid, a diluted sulfuric acid, a diluted phosphoric acid, a diluted nitric acid and a diluted acetic acid.

18. The method of claim 17, wherein the acid cleaning process is performed using a solution in which an acid and deionized water are mixed to an acid to deionized water ratio of about 1:100 to about 1:3,000.

19. The method of claim 15, further comprising:
dry cleaning remaining substances generated in a surface of the data metal film before the second dry etching of the data metal film, the dry cleaning process comprising at least one gas selected from the group consisting of a sulfur hexafluoride (SF₆) gas, an argon (Ar) gas, a boron trichloride (BCl₃) gas, a nitrogen trifluoride (NF₃) gas, a bromine (Br) gas and an oxygen (O₂) gas.

20. The method of claim 15, further comprising:
wet cleaning remaining substances generated in a surface of the data metal film before the second dry etching of the data metal film, the wet cleaning process comprising a tetramethylammonium hydroxide (TMAH) cleaning process, an isopropyl alcohol (IPA) cleaning process or a deionized water cleaning process.

21. The method of claim 15, wherein the dry etching of the first photoresist pattern is performed using a gas mixture with a ratio of sulfur hexafluoride (SF₆) gas to oxygen (O₂) gas of about 1:4 to about 1:20.

22. The method of claim 15, wherein the dry etching of the first photoresist pattern is performed using a gas mixture with a ratio of sulfur hexafluoride (SF₆) gas to oxygen (O₂) gas of about 1:30 to about 1:40.

23. The method of claim 15, further comprising:
removing the second photoresist pattern;
forming a passivation layer having an opening formed thereon to expose a portion of the data metal film in a substrate having the data metal film dry etched thereon; and
forming a pixel electrode on the passivation layer.
